# EUROPEAN PATENT APPLICATION

(11) **EP 2 811 503 A1**
(43) Date of publication of application: **10.12.2014**
(21) Application number: 12867582.4
(22) Date of filing: 21.11.2012
(51) Int. Cl.: H01H 13/00, A63F 5/04, H01H 36/00

(54) **PUSHBUTTON DEVICE AND GAME MACHINE**

(30) Priority: 03.02.2012 JP 2012021818
(71) Applicant: Omron Corporation, Kyoto-shi, Kyoto 600-8530 (JP)
(72) Inventor: SUGIYAMA, Hiroaki, Kyoto-shi Kyoto 600-8530 (JP); MORI, Syunji, Kyoto-shi Kyoto 600-8530 (JP); TANAKA, Atsushi, Kyoto-shi Kyoto 600-8530 (JP); FUNASAKA, Yuji, Kyoto-shi Kyoto 600-8530 (JP)
(74) Representative: Osha Liang SARL
(86) International application number: PCT/JP2012/080194
(87) International publication number: WO 2013/114709

(57) **Abstract**

A pushbutton device (1,10,20) includes: a button section (4) configured to be movable along a predetermined direction; a support section (2,3) configured to support the button section (4); plural first magnets (5-1 to 5-4) fixed to the support section (2,3) so as to surround a center of the button section (4), the plural first magnets (5-1 to 5-4) including a first magnetic pole on a side opposed to the button section (4); plural second magnets (5-5 to 5-8) arranged at a position farther away from the center of the button section (4) by a predetermined distance than each of the plural first magnets or at a position closer to the center of the button section (4) by the predetermined distance than the first magnet, the plural second magnets (5-5 to 5-8) including the first magnetic pole on the side opposite to the first magnet; and a sensor (6,8) configured to sense that the button section (4) is depressed by a predetermined amount.

## Description

### TECHNICAL FIELD

The present invention relates to a pushbutton device in which a magnet is used and a game machine provided with the pushbutton device.

### BACKGROUND ART

At least one pushbutton device is provided in a game machine such as a slot machine in order that a player operates the game machine. In the pushbutton device, desirably a feeling of depression of the pushbutton is provided to the player in order to prevent generation of a state in which the pushbutton is not depressed even if the player thinks to depress the pushbutton. For example, Japanese Unexamined Patent Publication No. 2-4029 proposes a pushbutton-type linear output device in which a pushing piece, which is provided in an upper portion of a box body so as to be able to progress and retreat, is supported using one spring.

### SUMMARY OF THE INVENTION

### PROBLEM TO BE SOLVED BY THE INVENTION

However, the player does not always depress the center of the button. When a depression position is close to an end portion of the button, sometimes the button inclines toward the depression direction. When the button inclines, there is a risk that the player does not have the good feeling when the button is depressed. Additionally, when the button inclines, possibly a sensor fails sometimes to sense the depression of the button. Therefore, there is a demand for the pushbutton device that can stabilize an attitude of the button when the button is depressed.

An object of the present invention is to provide a pushbutton device that can stabilize the attitude of the button when the button is depressed.

### MEANS FOR SOLVING THE PROBLEM

In accordance with one aspect of the present invention, a pushbutton device is provided. The pushbutton device includes: a button section configured to be movable along a predetermined direction, the button section including a first member located on an opposite side to a depression side; a support section configured to movably support the button section along the predetermined direction; plural first magnets opposed to the first member by the support section, the plural first magnets being fixed so as to surround a center of the button section, the plural first magnets having a first magnetic pole on a side opposed to the first member; plural second magnets arranged at a position farther away from the center of the button section by a predetermined distance than each of the plural first magnets or at a position closer to the center of the button section by the predetermined distance than the first magnet, the plural second magnets having the first magnetic pole on the side opposite to the first magnet; and a sensor configured to sense that the button section is depressed by a predetermined amount.

In the pushbutton device, preferably each of the plural first magnets and the plural second magnets is arranged along a straight line extending radially from the center of the button section.

In accordance with one aspect of the present invention, a game machine is provided. The game machine includes the pushbutton device and a control circuit configured to control, when receiving a signal expressing depression from the pushbutton device, operation of the game machine in response to the signal.

### EFFECT OF THE INVENTION

The pushbutton device according to the present invention has an advantageous effect that the attitude of the button can be stabilized when the button is depressed.

### BRIEF DESCRIPTION OF THE DRAWINGS

Fig. 1 is a schematic perspective view of a pushbutton device according to an embodiment of the present invention.
Fig. 2 is an exploded perspective view of the pushbutton device.
Fig. 3 is an exploded plan view of the pushbutton device.
Fig. 4 is a sectional perspective view of the pushbutton device when a section indicated by a line A-A' in Fig. 3 is viewed from an arrow direction.
Fig. 5A is a schematic diagram of a magnetic flux line when a button section of the pushbutton device is not depressed.
Fig. 5B is a schematic diagram of the magnetic flux line when the button section of the pushbutton device is depressed.
Fig. 6 is a circuit block diagram of a sensing circuit.
Fig. 7 is an operation flowchart of a depression determination and moving speed measurement processing.
Fig. 8 is a view illustrating an example of a time-speed conversion table.
Fig. 9 is a view illustrating an example of a voltage-speed conversion table.
Fig. 10 is a side sectional view of a pushbutton device according to a second modification when the section indicated by the line A-A' in Fig. 3 is viewed from the arrow direction.
Fig. 11 is a side sectional view of a pushbutton device according to a fourth modification when the section indicated by the line A-A' in Fig. 3 is viewed from the arrow direction.
Fig. 12 is a schematic perspective view of a game machine including the pushbutton device of the embodiment or the modifications.
Fig. 13 is a circuit block diagram of a control circuit of the game machine.

### MODE FOR CARRYING OUT THE INVENTION

A pushbutton device according to an embodiment of the present invention will be described with reference to the drawings. In the pushbutton device, repulsion generated by magnetic forces among plural magnets is used in order that a user feels elasticity when holding down a button section, which is supported while being movable in a predetermined direction. Plural sets of a magnet provided in a case base supporting the button section and a magnet, which is provided in the button section so as to be opposed to the magnet provided in the case base, are arranged so as to surround a center of the button section. Each magnet provided in the button section is arranged while separating from the center of the button section by a predetermined distance along a parabolic line connecting the center of the button section and the corresponding magnet provided in the case base. In magnetic forces generated by each set of the magnets, components parallel to a surface orthogonal to the direction in which the button section goes straight cancel each other, whereby an attitude of the button section is stabilized.

Hereinafter, for the sake of convenience of the description, it is assumed that a direction in which the button section is movable is set to a perpendicular direction. However, the direction in which the button section moves actually is properly decided according to an arrangement of the pushbutton device.

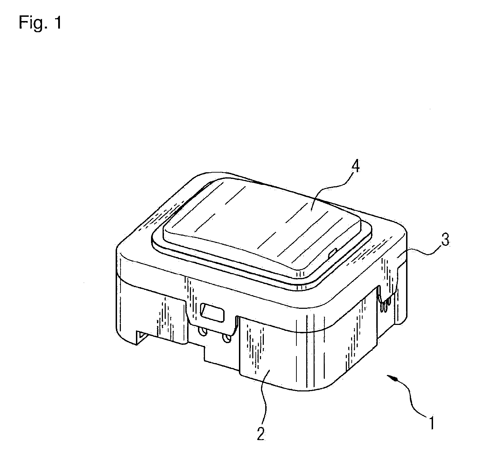

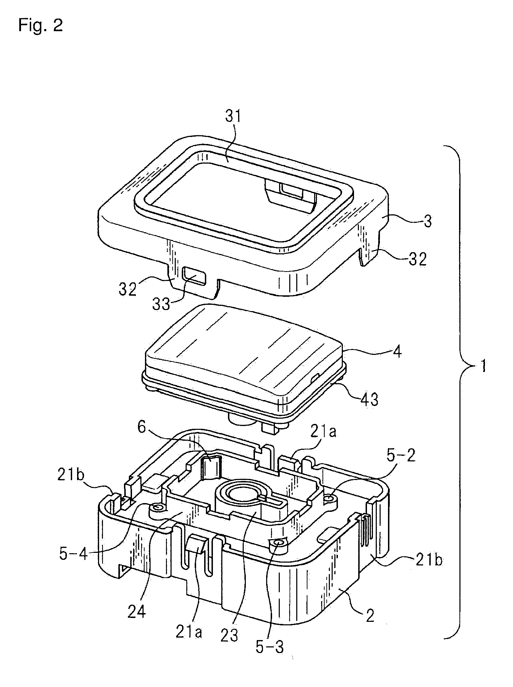

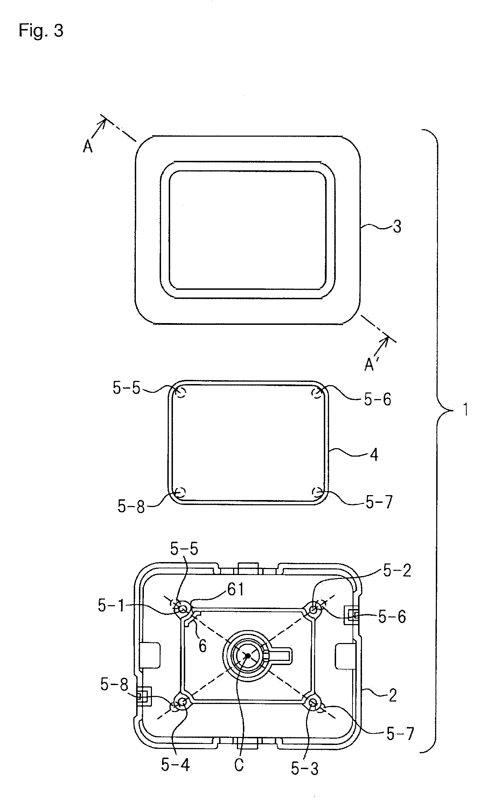

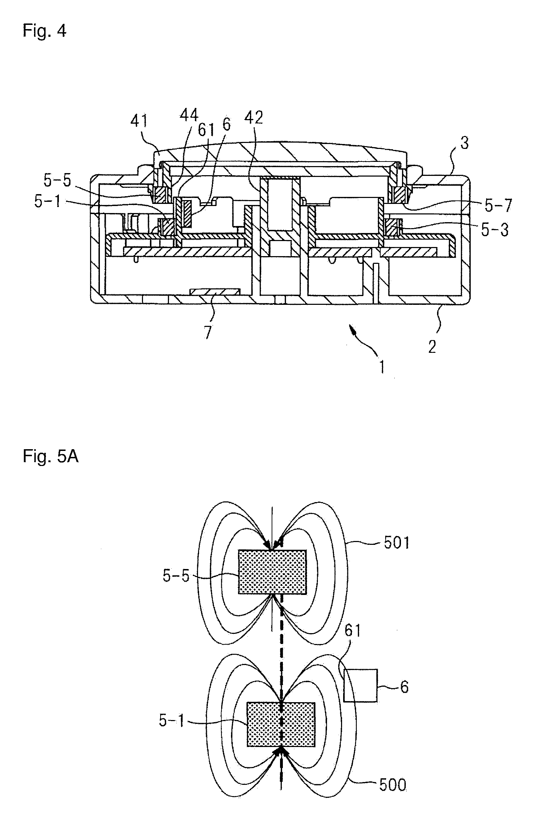

Fig. 1 is a schematic perspective view of pushbutton device 1 according to a first embodiment of the present invention, and Fig. 2 is an exploded perspective view of pushbutton device 1. Fig. 3 is an exploded plan view of pushbutton device 1. Fig. 4 is a sectional perspective view of the pushbutton device when a section indicated by a line A-A' in Fig. 3 is viewed from an arrow direction. Pushbutton device 1 includes case base 2, case cover 3, button section 4, four magnets 5-1 to 5-4 attached to case base 2, four magnets 5-5 to 5-8 attached to button section 4, magnetic sensor 6, and sensing circuit 7.

Case base 2 and case cover 3 constitute a support section that supports button section 4 such that button section 4 is movable along the perpendicular direction. Therefore, case base 2 includes sidewall 21 that is formed into a substantially square pipe shape along the perpendicular direction and bottom plate 22 that is arranged in sidewall 21 so as to be orthogonal to sidewall 21.

Latch 21 a that fixes case cover 3 to case base 2 and inwardly-recessed recess 21 b recessed in are provided in an outer periphery of sidewall 21. Cylindrical projection 23 is formed upward in a substantial center of bottom plate 22. A leading end of button lower portion 42 of button section 4 is inserted in projection 23 to restrain a position of button section 4 from deviating in a horizontal direction.

Quadrangular projection 24 is formed between sidewall 21 and projection 23 so as to surround projection 23 formed on a top surface of bottom plate 22 of case base 2. Magnets 5-1 to 5-4 are arranged at vertices of projection 24.

Case cover 3 is arranged above case base 2, and constitutes the support section together with case base 2. Substantially rectangular opening 31 is formed in the center of the top surface of case cover 3, and the upper portion of button section 4 is inserted in opening 31. Therefore, a size and a shape of opening 31 are substantially equal to those of the upper portion of button section 4.

The size of outer periphery of case cover 3 is substantially equal to that of case base 2. In a lower portion of the outer periphery of case cover 3, four projections 32 are formed along the perpendicular direction (however, only two projections 32 are illustrated in Figs. 1 and 2), and holes 33 are made in two of four projections 32 in order to engage latch 21 a formed in sidewall 21 of case base 2. Holes 33 engage latches 21 a, and remaining two projections 32 engage recess 21 b of sidewall 21 of case base 2, thereby fixing case cover 3 to case base 2. While case cover 3 is fixed to case base 2, a space where button section 4 is movable along the perpendicular direction is formed between case cover 3 and the top surface of bottom plate 22 of case base 2.

For example, case base 2 and case cover 3 are formed by resin injection molding.

Button section 4 is a member that moves in the perpendicular direction when the user holds down button section 4. Pushbutton device 1 outputs a signal expressing the depression when moving downward by a predetermined distance from a state in which button section 4 is not depressed. Therefore, button section 4 includes button upper portion 41 having a substantially rectangular solid shape and substantially cylindrical button lower portion 42 that is formed downward from the substantial center of a bottom surface of button upper portion 41.

An outer shape and a size of a side surface of button upper portion 41 are substantially equal to a shape and a size of opening 31 of case cover 3, and button upper portion 41 is inserted in opening 31 from the bottom surface side of case cover 3. Therefore, a player can directly holds down the top surface of button upper portion 41. Fringe 43 is formed in the lower portion of the outer periphery of button upper portion 41, and the size of the outer periphery of fringe 43 is larger than that of opening 31. When button section 4 is located at an upper end of a movable range, the top surface of fringe 43 abuts on the bottom surface of the outer periphery of opening 31 of case cover 3. Therefore, the button section 4 is prevented from dropping through opening 31.

The top surface of button upper portion 41 may be formed by a gentle curved surface having an upward convex shape in order that the user easily recognizes the button. Button upper portion 41 may be formed into a hollow shape. In this case, the top surface of button upper portion 41 may be made of a transparent or translucent resin. A light emitting element such as a light emitting diode is arranged in button upper portion 41, and an emission intensity of light emitting element may be adjusted by a moving speed of button section 4.

The outer shape and the size of button lower portion 42 are substantially equal to the shape and the size of projection 23 of case base 2, and button lower portion 42 is inserted in projection 23. Therefore, projection 23 of case base 2 and opening 31 of case cover 3 restrict the movable direction of button section 4 to the perpendicular direction.

On a bottom surface of button upper portion 41 of button section 4, namely, the opposite side to the depression side, quadrangular projection 44 is formed downward along the outer periphery of button upper portion 41. The shape in section of projection 44 is similar to that of rectangular projection 24 formed in case base 2, and projection 44 is formed so as to surround projection 24. Accordingly, magnets 5-1 to 5-4 are opposed to projection 44.

For example, each section constituting button section 4 is formed by the resin injection molding.

Magnets 5-5 to 5-8 are arranged at vertices of projection 44. Therefore, magnets 5-1 to 5-8 are arranged so as to surround center C in a horizontal surface of button section 4. Center C is located on a center axis of button section 4 along the perpendicular direction.

The positions of magnets 5-5 to 5-8 are indicated by broken lines in Fig. 3 on case base 2 for the sake of easy understanding of a positional relationship between magnets 5-1 to 5-4 and magnets 5-5 to 5-8. As is clear from Fig. 3, magnets 5-5 to 5-8 are located on a straight line that extends radially from center C on the center axis so as to pass through magnets 5-1 to 5-4, and magnets 5-5 to 5-8 are farther away from center C by a predetermined distance than magnets 5-1 to 5-4. The predetermined distance is set to an extent to which button section 4 can be biased upward by the repulsion of the magnetic forces between the two magnets corresponding to each other, for example, 1 mm to 5 mm. Magnets 5-1 to 5-4 have the same magnetic force, and magnets 5-5 to 5-8 also have the same magnetic force. Each of magnets 5-1 to 5-8 may be formed by a permanent magnet such as a neodymium magnet or an electromagnet.

Magnetic poles on the upper end sides of magnets 5-1 to 5-4 are identical to those on the lower end sides of magnets 5-5 to 5-8. The magnetic forces of magnets 5-1 to 5-4 and the magnetic forces of magnets 5-5 to 5-8 are repulsed by each other to bias button section 4 toward the upward direction, namely, the direction separating from case base 2, and therefore, button section 4 is located at the upper end of the movable range unless button section 4 is depressed. When button section 4 is depressed, the user can feel an elastic force corresponding to the magnetic force. Therefore, pushbutton device 1 can provide a feeling of the depression of the button to the user. When the user releases a finger from button section 4, button section 4 moves upward by the magnetic force until reaching the upper end of the movable range.

Each of magnets 5-1 and 5-3 and magnets 5-5 and 5-7 is located on one line passing through center C. Therefore, a horizontal component of a force acting on button section 4 by interaction between the magnetic forces of magnets 5-1 and 5-5 and a horizontal component of a force acting on button section 4 by interaction between the magnetic forces of magnets 5-3 and 5-7 are inverted to cancel each other. Similarly, each of magnets 5-2 and 5-4 and magnets 5-6 and 5-8 is located on another line passing through center C. A horizontal component of the force acting on button section 4 by the interaction between the magnetic forces of magnets 5-2 and 5-6 and a horizontal component of the force acting on button section 4 by the interaction between the magnetic forces of magnets 5-4 and 5-8 are inverted to cancel each other. Because a balance between the horizontal components of the forces acting on button section 4 is established by the magnets, button section 4 is prevented from deviating in the horizontal direction when button section 4 is depressed. In each corner of button section 4, the inclination of button section 4 is also prevented because repulsion forces along the perpendicular direction are substantially equal to each other. As a result, the attitude of button section 4 is easily stabilized when the user depresses button section 4, so that the depression feeling of the button can be improved for the user in pushbutton device 10.

For example, magnetic sensor 6 includes a Hall element to sense magnetic flux densities. The magnetic flux densities are generated by the magnet attached to case base 2 and the magnet attached to button section 4, changes according to a distance between the two magnets, and pierces magnetic sensitive surface 61. Therefore, preferably magnetic sensor 6 is arranged such that an angle at which the magnetic flux outgoing from one of the two magnets is incident to magnetic sensitive surface 61 is brought close to perpendicularity with decreasing distance between the magnets. Preferably magnetic sensor 6 is arranged such that the magnetic flux density incident to magnetic sensitive surface 61 from the other magnet increases with decreasing distance between the two magnets.

In the embodiment, magnetic sensor 6 is arranged close to the side surface of magnet 5-1, and magnetic sensor 6 is arranged on the side of center C with respect to magnet 5-1 such that button section 4 and magnetic sensor 6 do not come into contact with each other when button section 4 is depressed. Magnetic sensitive surface 61 of magnetic sensor 6 is oriented so as to become substantially parallel to the perpendicular direction and so as to be opposed to magnets 5-1 and 5-5. Magnetic sensor 6 is installed such that the upper end of magnet 5-1 is located below the upper end of magnetic sensitive surface 61, namely such that the upper end of magnetic sensitive surface 61 is closer to button section 4 than the upper end of magnet 5-1 when button section 4 is not depressed. Therefore, magnetic sensor 6 can sense changes in densities of the magnetic fluxes passing through magnetic sensitive surface 61 from magnets 5-1 and 5-5 with high sensitivity. The change in magnetic flux density is generated by the movement of button section 4 in the perpendicular direction.

More preferably magnetic sensor 6 is arranged such that the upper end of magnetic sensitive surface 61 is located above the bottom surface of magnet 5-5 when button section 4 is located at the lower end of the movable range, and such that the upper end of magnetic sensitive surface 61 is located below the bottom surface of magnet 5-5 when button section 4 is located at the upper end of the movable range. Therefore, because of an increasing difference between the magnetic flux density transmitted through magnetic sensitive surface 61 when button section 4 is located at the upper end of the movable range and the magnetic flux density transmitted through magnetic sensitive surface 61 when button section 4 is located at the lower end of the movable range, sensing circuit 7 accurately obtains the moving speed of button section 4 based on a signal output from magnetic sensor 6.

Magnetic sensor 6 may be arranged close to one of magnets 5-2 to 5-4 instead of magnet 5-1. In this case, preferably magnetic sensitive surface 61 of magnetic sensor 6, magnets 5-2 to 5-4, and magnets 5-6 to 5-8 are arranged such that the positional relationship among magnetic sensitive surface 61, magnets 5-2 to 5-4, and magnets 5-6 to 5-8 is similar to that among magnetic sensitive surface 61, magnet 5-1, and magnet 5-5 in the embodiment.

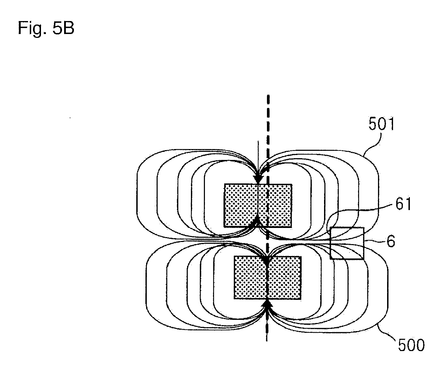

Fig. 5A is a schematic diagram of a magnetic flux line when button section 4 of the pushbutton device is not depressed, and Fig. 5B is a schematic diagram of the magnetic flux line when button section 4 is depressed. In Figs. 5A and 5B, lines 500 and 501 express the magnetic flux lines output from magnets 5-1 and 5-5, respectively.

As illustrated in Fig. 5A, because magnets 5-1 and 5-5 separate from each other while button section 4 is not depressed, magnetic flux lines 500 outgoing from the top surface of magnet 5-1 are hardly influenced by magnet 5-5, and therefore magnetic flux lines 500 are obliquely incident to magnetic sensitive surface 61 of magnetic sensor 6 located near the top surface of magnet 5-1. Because magnet 5-5 and magnetic sensor 6 separate from each other, few magnetic flux lines reach magnetic sensitive surface 61 in magnetic flux lines 501 outgoing from magnet 5-5. Therefore, the relatively low magnetic flux density is sensed by magnetic sensor 6.

On the other hand, as illustrated in Fig. 5B, when button section 4 is depressed to narrow an interval between magnets 5-1 and 5-5, magnetic flux lines 500 outgoing from the top surface of magnet 5-1 and magnetic flux lines 401 outgoing from the bottom surface of magnet 5-5 are mutually influenced. Magnetic flux lines 500 are laterally curved on the lower side compared with the widen interval between magnets 5-1 and 5-5. As a result, the magnetic flux line density increases in magnetic sensitive surface 61 because of the increased number of magnetic flux lines substantially perpendicularly incident to magnetic sensitive surface 61. Because of the narrowed interval between magnet 5-5 and magnetic sensitive surface 61, the density of magnetic flux line 501 that is outgoing from the bottom surface of magnet 5-5 and is transmitted through sensitive surface 61 also increases. Therefore, the relatively high magnetic flux density is sensed by magnetic sensor 6.

When button section 4 is depressed to move along the perpendicular direction, the distance between magnets 5-1 and 5-5 is shortened according to the movement of button section 4, thereby changing the magnetic flux density sensed by magnetic sensor 6. Accordingly, the change in magnetic flux density sensed by magnetic sensor 6 expresses a displacement of button section 4.

Magnetic sensor 6 outputs a voltage corresponding to the sensed magnetic flux density to sensing circuit 7.

Based on the voltage output from magnetic sensor 6, sensing circuit 7 obtains the moving speed of button section 4 while determining whether button section 4 is depressed. Therefore, sensing circuit 7 is arranged on a board (not illustrated) in a space between case base 2 and case cover 3, and connected to magnetic sensor 6 through a signal line. Alternatively, sensing circuit 7 may be arranged on a board provided outside case base 2 and case cover 3. Sensing circuit 7 is also connected to a main control circuit (not illustrated) of a game machine provided with pushbutton device 1 through a signal line, and sensing circuit 7 outputs a signal expressing the depression of button section 4 and a signal expressing the moving speed of button section 4 to the main control circuit.

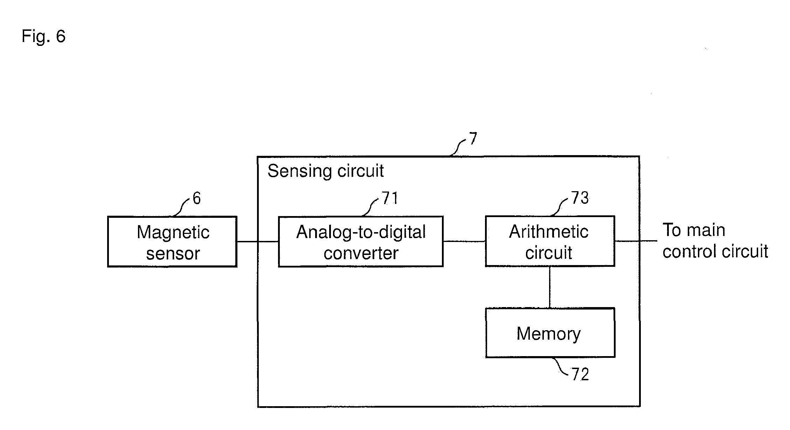

Fig. 6 is a circuit block diagram of sensing circuit 7. Sensing circuit 7 includes analog-to-digital converter 71, memory 72, and arithmetic circuit 73. Analog-to-digital converter 71, memory 72, and arithmetic circuit 73 may separately be formed, or integrally be formed as one integrated circuit.

Analog-to-digital converter 71 converts the voltage output from magnetic sensor 6 into a voltage signal that is of a digital signal corresponding to the output voltage, and outputs the voltage signal to arithmetic circuit 73. The voltage output from magnetic sensor 6 is amplified by an amplifier, and the amplified output voltage may be input to analog-to-digital converter 71.

For example, memory 72 includes a nonvolatile, unwritable semiconductor memory and a volatile, writable semiconductor memory. Data used to determine whether button section 4 is depressed and data used to detect the moving speed of button section 4 are stored in memory 72. For example, a voltage threshold used to determine whether button section 4 is depressed and a time-speed conversion table expressing a relationship between a counter value expressing a time necessary for button section 4 to move between predetermined two points and the moving speed of button section 4 are stored in memory 72.

For example, arithmetic circuit 73 is constructed with a general-purpose processor or a dedicated arithmetic circuit constructed as an ASIC. Based on the voltage signal, which is received from analog-to-digital converter 71 and corresponds to the voltage output from magnetic sensor 6, arithmetic circuit 73 determines whether button section 4 is depressed and obtains the moving speed of button section 4 again.

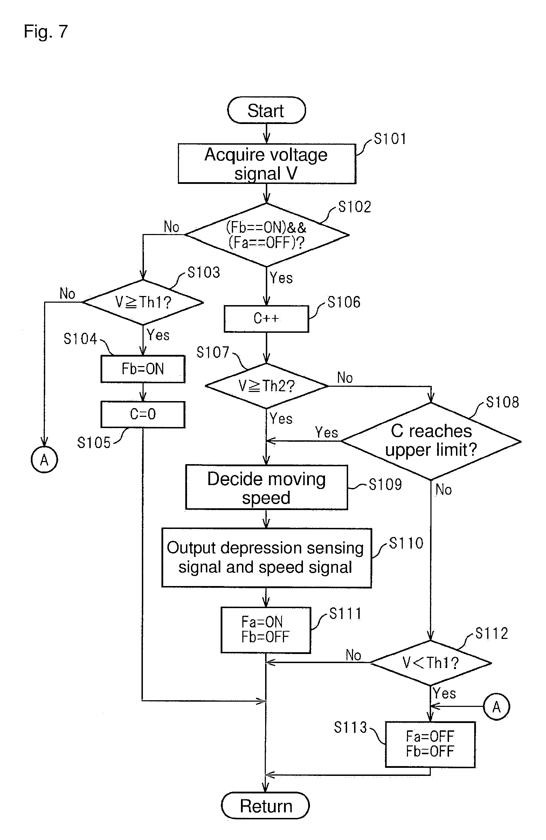

Fig. 7 is an operation flowchart of the depression determination and moving speed measurement processing, which are performed by arithmetic circuit 73. Arithmetic circuit 73 performs the depression determination and the moving speed measurement processing according to the following operation flowchart at each given cycle. The given cycle is set to a time shorter than a time necessary for the user to perform the depression operation of the button once, for example, 20 µs.

When pushbutton device 1 is powered on, arithmetic circuit 73 sets depression flag Fb expressing whether pushbutton device 1 is in a state in which a depression pressure is applied to button section 4 to an off state expressing that the depression pressure is not applied as an initial setting. Arithmetic circuit 73 also sets depressed flag Fa expressing whether pushbutton device 1 returns to the state in which the depression pressure is not applied to button section 4 after pushbutton device 1 is depressed once to an off state expressing that button section 4 returns to the state in which the depression pressure is not applied. Arithmetic circuit 73 also sets counter C to a value of zero expressing the number of times the voltage signal value is obtained after the depression pressure is applied to button section 4.

Arithmetic circuit 73 acquires voltage signal V corresponding to the output voltage of magnetic sensor 6 from analog-to-digital converter (Step S101). Arithmetic circuit 73 determines whether depressed flag Fa is in the off state while depression flag Fb is in an on state expressing that the depression pressure is applied to button section 4 (Step S102). When depression flag Fb is in the off state, or when depressed flag Fa is in an on state expressing that pushbutton device 1 does not return to the state in which the depression pressure is not applied to button section 4 (No in Step S102), arithmetic circuit 73 determines whether voltage signal V is greater than or equal to measurement start threshold Th1 (Step S103). For example, measurement start threshold Th1 is set to the voltage signal value at which button section 4 is located below the upper end of the movable range by a predetermined distance (for example, 1 mm to 2 mm). When voltage signal V is greater than or equal to measurement start threshold Th1 (Yes in Step S103), arithmetic circuit 73 determines that the depression pressure is applied to button section 4. Therefore, arithmetic circuit 73 sets depression flag Fb to the on state (Step S104). Arithmetic circuit 73 also resets counter C to the value of zero (Step S105). The order of the pieces of processing in Steps S104 and S105 may be changed. Then arithmetic circuit 73 waits for the acquisition of next voltage signal V.

On the other hand, when voltage signal V is less than measurement start threshold Th1 (No in Step S103), arithmetic circuit 73 determines that pushbutton device 1 returns to the initial state in which the depression pressure is not applied to button section 4. Therefore arithmetic circuit 73 sets depressed flag Fa and depression flag Fb to the off state (Step S113). Then arithmetic circuit 73 waits for the acquisition of next voltage signal V.

On the other hand, in Step S102, when depression flag Fb is turned on while depressed flag Fa is in the off state (Yes in Step S102), arithmetic circuit 73 increments the value of counter C by one (Step S106). Arithmetic circuit 73 determines whether voltage signal V is greater than or equal to depression sensing threshold Th2 (Step S107). Depression sensing threshold Th2 is set to a voltage signal value corresponding to the position where button section 4 is determined to be depressed. Therefore, depression sensing threshold Th2 is larger than sensing start threshold Th1. That is, the position of button section 4 corresponding to depression sensing threshold Th2 is lower than the position of button section 4 corresponding to sensing start threshold Th1.

When voltage signal V is less than depression sensing threshold Th2 (No in Step S107), button section 4 does not move downward as it is determined to be depressed. In this case, arithmetic circuit 73 determines whether the value of counter C reaches an upper limit (for example, 1000) (Step S108). When the value of counter C reaches the upper limit (Yes in Step S108), or when voltage signal V is greater than or equal to depression sensing threshold Th2 in Step S107 (Yes in Step S107), arithmetic circuit 73 determines that button section 4 is depressed. Arithmetic circuit 73 obtains the moving speed of button section 4 based on counter C or voltage signal V (Step S109).

At this point, when voltage signal V is greater than or equal to depression sensing threshold Th2, button section 4 is estimated to move to the position corresponding to depression sensing threshold Th2 from the position corresponding to sensing start threshold Th1 within a time period obtained by multiplying the value of counter C and a voltage signal acquisition cycle. Arithmetic circuit 73 can calculates the moving speed of button section 4 by dividing difference Δ between the distance between magnets 5-1 and 5-5 at the position corresponding to sensing start threshold Th1 and the distance between magnets 5-1 and 5-5 at the position corresponding to depression sensing threshold Th2 by a cycle (C x P) obtained by multiplying the value of counter C and voltage signal acquisition cycle P. For example, difference Δ and voltage signal acquisition cycle P are previously stored in memory 72 because difference Δ and voltage signal acquisition cycle P are well known values.

Alternatively, a time-speed conversion table expressing a relationship between the value of counter C and the moving speed may previously be stored in memory 72. In this case, arithmetic circuit 73 refers to the time-speed conversion table to specify the moving speed corresponding to the value of counter C, which allows the moving speed of button section 4 to be obtained.

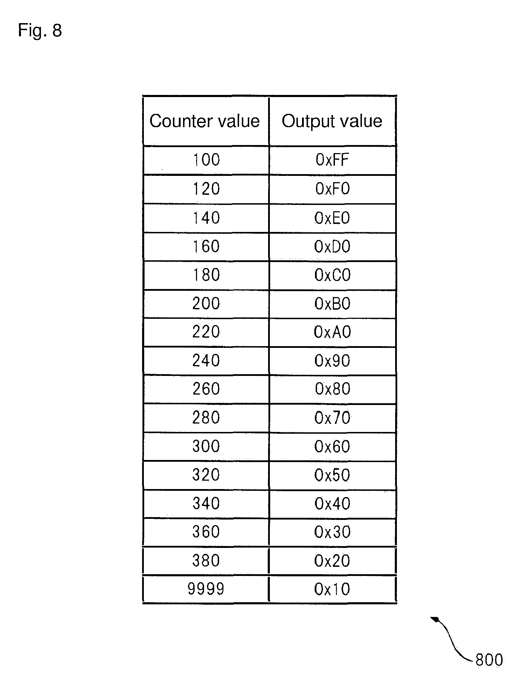

Fig. 8 is a view illustrating an example of the time-speed conversion table. A reference value of counter C is stored in each field of a left column of time-speed conversion table 800 in Fig. 8, and an output value expressing the moving speed corresponding to the reference value is stored in each field of a right column. The output value is hexadecimally expressed. For example, a value'0 x 10' stored in the bottom field corresponds to 0.5 mm/s, and a value '0 x FF' stored in the top field corresponds to 50 mm/s. When voltage signal V becomes greater than or equal to depression sensing threshold Th2, arithmetic circuit 73 compares the value of counter C to the reference value stored in each field in the descending order of time-speed conversion table 800. When the value of counter C becomes less than or equal to the reference value, arithmetic circuit 73 specifies the value of the moving speed stored in the same row as the reference value as the moving speed of button section 4.

The relationship between voltage signal V and the position of button section 4 is well known because the relationship can previously be measured by an experiment. In the case that the value of counter C reaches the upper limit, an elapsed time since button section 4 is depressed to the position corresponding to sensing start threshold Th1 becomes a value in which upper limit Climit is multiplied by voltage signal acquisition cycle P. Therefore, based on voltage signal V when the value of counter C reaches the upper limit, arithmetic circuit 73 obtains difference d between the distance between magnets 5-1 and 5-5 at the position corresponding to sensing start threshold Th1 and the distance between magnets 5-1 and 5-5 at the position corresponding to voltage signal V, and arithmetic circuit 73 can obtain the moving speed of button section 4 by dividing difference d by the elapsed time (Climit x P). A displacement conversion table expressing the relationship between voltage signal V and difference d is previously stored in memory 72.

Because the elapsed time (Climit x P) is also a well known value, the relationship between voltage signal V and the moving speed obtained by dividing the difference d by the elapsed time (Climit x P) can be previously obtained by an experiment. Instead of the displacement conversion table, a voltage-speed conversion table expressing a correspondence between voltage signal V and the moving speed of button section 4 may be stored in memory 72. In this case, arithmetic circuit 73 can refer to the voltage-speed conversion table to specify the moving speed corresponding to voltage signal V.

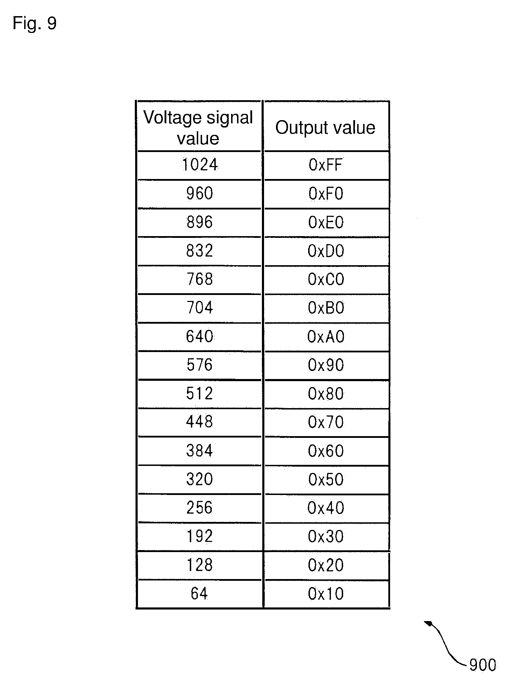

Fig. 9 is a view illustrating an example of the voltage-speed conversion table. A reference value of voltage signal V digitized by analog-to-digital converter 71 is stored in each field of a left column of voltage-speed conversion table 900 in Fig. 9, and an output value expressing the moving speed is stored in each field of a right column. The output value is hexadecimally expressed. For example, a value'0 x 10' stored in the bottom field corresponds to 0.5 mm/s, and a value '0 x FF' stored in the top field corresponds to 50 mm/s. When the value of counter C reaches upper limit Climit, arithmetic circuit 73 compares the value of voltage signal V with the reference value stored in each field in the descending order of voltage-speed conversion table 800. When the value of voltage signal V becomes less than or equal to the reference value, arithmetic circuit 73 specifies the value of the moving speed stored in the same row as the reference value as the moving speed of button section 4.

When obtaining the moving speed of button section 4, arithmetic circuit 73 outputs a depression sensing signal expressing that the depression of button section 4 is sensed and a speed signal expressing the moving speed to the main control circuit (not illustrated) of the game machine (not illustrated) (Step S110). Arithmetic circuit 73 sets depressed flag Fa to the on state and sets depression flag Fb to the off state such that the plural depression sensing signals are not output by one-time depression (Step S111). Then arithmetic circuit 73 waits for the acquisition of next voltage signal V.

On the other hand, in Step S108, when the value of counter C does not reach the upper limit (No in Step S108), arithmetic circuit 73 determines whether voltage signal V is less than sensing start threshold Th1 (Step S112). When voltage signal V is less than sensing start threshold Th1 (Yes in Step S112), it is estimated that button section 4 returns to the position where the pressure is not applied, and it is estimated that the user releases the finger from button section 4 before the sensing of the depression of button section 4. Therefore arithmetic circuit 73 sets depressed flag Fa and depression flag Fb to the off state (Step S113). After Step S113, or when voltage signal V becomes greater than or equal to sensing start threshold Th1 in Step S112 (No in Step S112), arithmetic circuit 73 waits for the acquisition of next voltage signal V.

As described above, in the pushbutton device, the plural sets of magnets attached onto the case base side and the magnets attached onto the button section side are provided, and the plural sets of magnet are arranged so as to surround center C and such that the magnet located on the button section side is located outside the corresponding magnet on the case base side. In the pushbutton device, the horizontal components of the forces acting on the button section by each set of magnets cancel each other, and the attitude of the button section can be stabilized. Therefore, in the pushbutton device, the user easily depresses the button section straight along the perpendicular direction, and the depression feeling of the button can be improved. In the pushbutton device, by sensing the magnetic force from the magnet, not only the depression of the button section is sensed but also the moving speed of the button section can be obtained. In the pushbutton device, the moving speed can be output as useful information expressing the user operation to the device that is controlled according to the user operation to depress the button section. In the pushbutton device, in order to obtain the moving speed of the button section, the magnetic sensor can sense the difference between the magnetic flux density when the button section is located at the upper end of the movable range and the magnetic flux density when the button section is located at the lower end of the movable range. Therefore, in the pushbutton device, because the movable range of the button section can be shortened, the whole pushbutton device can be downsized in the perpendicular direction. In the pushbutton device, the magnetic sensor is arranged at the position where the magnetic flux line outgoing from the two magnets are influenced by the distance between the magnets. Therefore, the positional change of the button section can be acutely sensed, so that the movable range of the button section can be shortened. In the pushbutton device, only one magnetic sensor is used to sense the moving speed of the button section and the depression of the button section, so that a space where the sensor is arranged can be reduced. Accordingly, the pushbutton device can be downsized.

According to a first modification, the plural magnets attached onto the button section side may be arranged so as to be closer to center C by a predetermined distance (for example, 1 mm to 5 mm) than the corresponding magnets attached onto the case base side. The number of magnets attached onto the button section side and the number of magnets attached onto the case base side are not limited to four, respectively. The pushbutton device includes at least three sets of magnets, which are attached onto the case base side corresponding to the magnets attached onto the button section side, and each set of magnets may be arranged such that the horizontal components of the forces acting on the button section by each set of magnets cancel each other. For example, the pushbutton device includes the three sets of magnets, and the sets of magnets may be arranged at vertices of an equilateral triangle in which a barycenter is set to center C. In this case, each magnet attached onto the button section side is arranged so as to separate from center C by a predetermined distance along a radial line passing through the corresponding magnet attached onto the case base side and center C or so as to come close to center C by the predetermined distance along the radial line.

According to a second modification, in addition to the magnetic sensor, the pushbutton device may include a sensor that senses that the button lower portion is depressed to the sensing start position.

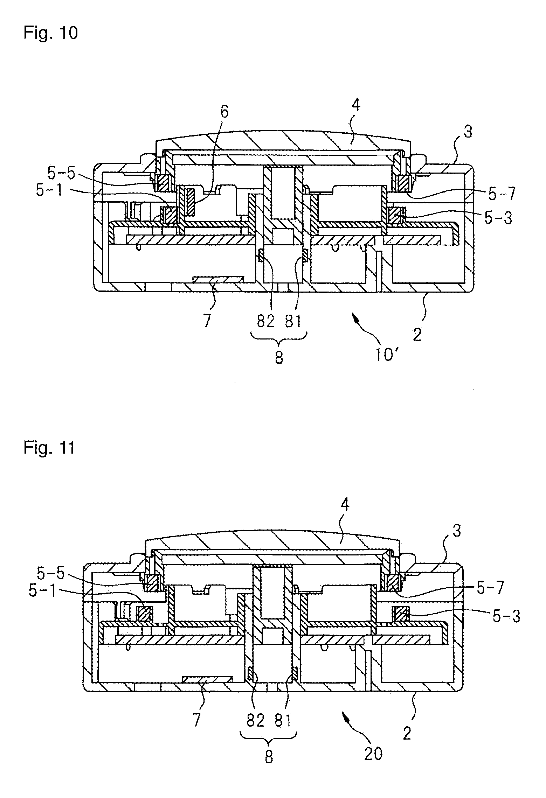

Fig. 10 is a side sectional view of a pushbutton device according to the second modification when the section indicated by the line A-A' in Fig. 3 is viewed from the arrow direction. Pushbutton device 10 of the second modification includes case base 2, case cover 3, button section 4, four sets of magnets, magnetic sensor 6, sensing circuit 7, and optical sensor 8. Only two sets of magnets in the four sets of magnets, namely, magnets 5-1 and 5-5 and magnets 5-3 and 5-7 are illustrated in Fig. 10. Pushbutton device 10 differs from pushbutton device 1 in that pushbutton device 10 includes optical sensor 8. Optical sensor 8 and an associated portion will be described below.

Optical sensor 8 includes light emitting element 81 such as a light emitting diode and a light receiving element 82 such as a photodiode. While the power is supplied to pushbutton device 10, light emitting element 81 is lit, and light receiving element 82 outputs a signal corresponding to intensity of the sensed light to sensing circuit 7. While button section 4 is not depressed, light emitting element 81 and light receiving element 82 are arranged below the lower end of button lower portion 42 by a predetermined distance (for example, 1 mm to 2 mm) so as to be opposed to each other in projection 24 of case base 2. Unless button section 4 is depressed, light receiving element 82 senses the light emitted from light emitting element 81, the intensity of the signal output to sensing circuit 7 from light receiving element 82 is relatively increased. On the other hand, when button section 4 is depressed to move downward, button lower portion 42 interposes between light emitting element 81 and light receiving element 82, and interrupts the light emitted from light emitting element 81. Because light receiving element 82 cannot sense the light, the intensity of the signal output to sensing circuit 7 from light receiving element 82 is relatively decreased. Accordingly, instead of comparing the voltage signal received from magnetic sensor 6 with threshold Th1 in Steps S103 and S112 of the operation flow of the depression determination and the moving speed measurement processing in Fig. 7, sensing circuit 7 compares the intensity of the signal received from light receiving element 82 with luminance threshold corresponding to the intensity of the signal during the time light receiving element 82 senses the light emitted from light emitting element 81, which allows the determination whether the depression pressure is applied to button section 4. For example, sensing circuit 7 can determine that the depression pressure is applied to button section 4 when the intensity of the signal received from light receiving element 82 is less than the luminance threshold corresponding to the intensity of the signal during the time light receiving element 82 senses the light emitted from light emitting element 81, and sensing circuit 7 can determine that the depression pressure is not applied to button section 4 when the intensity of the signal received from light receiving element 82 is greater than or equal to the luminance threshold.

According to a third modification, the magnetic sensor may be fixed to the button section. In order to be able to sense the magnetic flux density that changes according to the distance between the magnet attached to the button section and the magnet attached to the case base, the magnetic sensor is arranged such that the magnetic sensitive surface of the magnetic sensor is substantially parallel to the perpendicular direction, and such that the magnetic sensor faces the magnet attached to the button section and the magnet attached to the case base. Preferably the magnetic sensor is arranged such that an angle at which the magnetic flux outgoing from the magnet attached to the button section is incident to the magnetic sensitive surface comes close to the perpendicularity with decreasing distance between the magnet attached to the button section and the magnet attached to the case base, and such that the density of the magnetic flux, which is outgoing from the magnet attached to the case base and incident to the magnetic sensitive surface, is enhanced with decreasing distance between the magnet attached to the button section and the magnet attached to the case base. Therefore, preferably the magnetic sensor is arranged such that the lower end of the magnetic sensitive surface is located below the lower end of the button section.

According to a fourth modification, the pushbutton device may determine whether the button section is depressed using the optical sensor. Additionally, the pushbutton device needs not sense the moving speed of the button.

Fig. 11 is a side sectional view of a pushbutton device according to the fourth modification when the section indicated by the line A-A' in Fig. 3 is viewed from the arrow direction. Pushbutton device 20 of the fourth modification includes case base 2, case cover 3, button section 4, four sets of magnets, sensing circuit 7, and optical sensor 8. Only two sets of magnets in the four sets of magnets, namely, magnets 5-1 and 5-5 and magnets 5-3 and 5-7 are illustrated in Fig. 11. Pushbutton device 20 differs from pushbutton device 10 in Fig. 10 in that pushbutton device 20 does not include magnetic sensor 6 but optical sensor 8 is used to determine whether the button section is depressed. Optical sensor 8 will be described below.

Optical sensor 8 includes light emitting element 81 such as a light emitting diode and a light receiving element 82 such as a photodiode. While the power is supplied to pushbutton device 10, light emitting element 81 is lit, and light receiving element 82 outputs a signal corresponding to intensity of the sensed light to sensing circuit 7. While button section 4 is located at the lower end of the movable range, light emitting element 81 and light receiving element 82 are arranged above the lower end of button lower portion 42 by a predetermined distance (for example, 1 mm to 2 mm) so as to be opposed to each other in projection 24 of case base 2. When button section 4 is depressed to move to a neighborhood of the lower end of the movable range, light receiving element 82 of optical sensor 8 outputs a signal value lower than that during the time button section 4 is not depressed.

Therefore, sensing circuit 7 can determine that button section 4 is depressed when the intensity of the signal received from light receiving element 82 is less than the luminance threshold, and sensing circuit 7 can determine that button section 4 is not depressed when the intensity of the signal received from light receiving element 82 is greater than or equal to the luminance threshold.

In pushbutton device 20, magnets 5-5 to 5-8 are arranged closer to the center of button section 4 by a predetermined distance than magnets 5-1 to 5-4. Even if the magnets are arranged in this way, because the horizontal components of the repulsion forces generated by each set of magnets (such as magnets 5-1 and 5-5 and magnets 5-3 and 5-7) cancel each other, the attitude of button section 4 is stabilized during the depression.

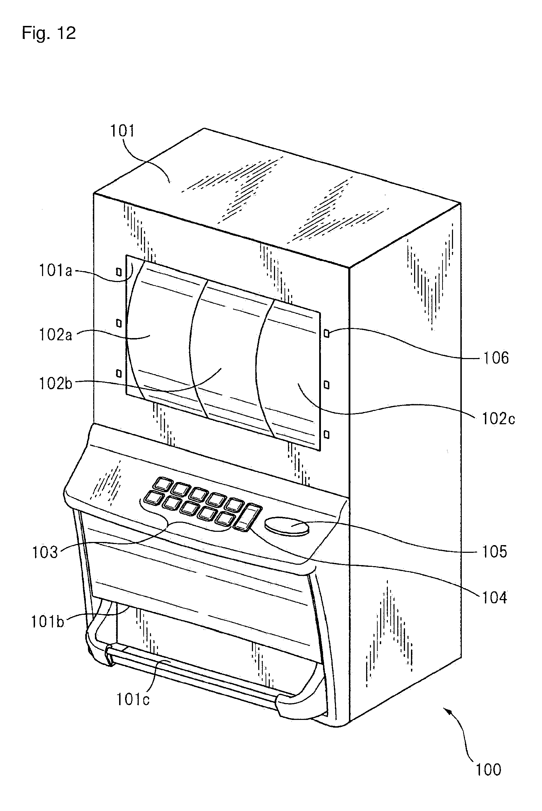

Fig. 12 is a schematic perspective view of game machine 100 including the pushbutton device of the embodiment or the modifications of the present invention. Game machine 100 includes body chassis 101 that is of a game machine body, three reels 102a to 102c, plural operation buttons 103, start button 104, and selection button 105. Game machine 100 also includes control circuit 110 in body chassis 101.

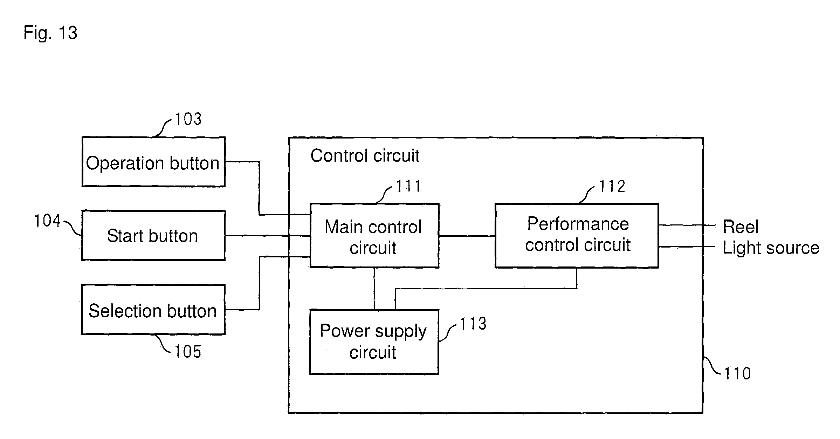

Fig. 13 is a circuit block diagram of control circuit 110. As illustrated in Fig. 13, control circuit 110 includes main control circuit 111 that controls whole game machine 100, performance control circuit 112 that controls each section related to performance of a game, and power supply circuit 113 that supplies power to each section of game machine 100.

Opening 101 a is formed in a central upper portion in a front surface of body chassis 101, and reels 102a to 102c can visually recognized through opening 101 a. A lower side of opening 101 a is formed so as to project onto a front surface side, and a top surface of the projection portion is formed into a table shape. In the table-shape portion, plural operation buttons 103, start button 104, and selection button 105 are sequentially arranged from the left when game machine 100 is viewed from the front surface. Operation button 103, start button 104, and selection button 105 are constructed with the pushbutton device of the embodiment or the modifications.

Token ejection port 101 b through which a medal is ejected is formed in a lower portion of the front surface of body chassis 101. Token receiving tray 101 c is attached below medal ejection port 101 b in order to prevent the ejected token from dropping. A speaker (not illustrated) may be attached near the left or right upper end of body chassis 101. Plural ornamental light emitting diodes 106 may be attached around opening 101 a of body chassis 101 and each operation button 103 or in the button section of each operation button 103.

Reels 102a to 102c are an example of a movable section. In response to a control signal from performance control circuit 112, reels 102a to 102c can rotate separately about a rotation axis (not illustrated) that is substantially parallel to and horizontal to the front surface of body chassis 101. A surface of each of reels 102a to 102c is divided into plural regions having a substantially equal width along the rotation direction, and various graphics are drawn in each region. Instead of reels 102a to 102c, a display device such as a liquid crystal display may be provided such that a display screen of the display device can visually be recognized through opening 101 a. In this case, the display device displays an image simulatively exhibiting plural drums in response to the control signal from performance control circuit 112.

When at least one token is input to game machine 100 through a token inlet port (not illustrated), a token identification device (not illustrated) senses the token every time the token is input, and notifies main control circuit 111 that the token is sensed. Main control circuit 111 decides the number of play times according to the number of input tokens, and permits game machine 100 to start a game.

Then the player depresses a predetermined operation button in plural operation buttons 103. In plural lines connecting the plural graphics across the three reels, main control circuit 111 selects a line corresponding to the operation button as a prize line when the same graphics are arrayed along the line. When a button corresponding to the number of bets is depressed in plural operation buttons 103, main control circuit 111 changes the number of bets according to the number of depression times of the button.

Depressed operation button 103 notifies main control circuit 111 of the moving speed of the button section of operation button 103. Main control circuit 111 outputs the signal expressing the moving speed or the control signal corresponding to the moving speed to performance control circuit 112. In response to the signal expressing the moving speed or the control signal, performance control circuit 112 changes an emission intensity or an emission color of the light emitting diode arranged in or around operation button 103. For example, with increasing moving speed of the button section of the depressed operation button, performance control circuit 112 increases the emission intensity of the light emitting diode arranged in or around the operation button. Alternatively, in the plural light emitting diodes arranged around opening 101 a, performance control circuit 112 may increase the emission intensities of the light emitting diodes located at both ends of the prize line corresponding to depressed operation button 103 with increasing moving speed of the button section of the operation button. Main control circuit 111 may display a warning message of a breakdown in the display (not illustrated) when the moving speed exceeds a predetermined threshold.

When start button 104 is operated after the prize line and the number of bets are set, the signal indicating that start button 104 is depressed and the moving speed of the button section of start button 104 are transmitted to main control circuit 111. Main control circuit 111 causes performance control circuit 112 to start the rotations of reels 102a to 102c. Performance control circuit 112 increases rotation speeds of reels 102a to 102c increasing moving speed of the button section of depressed start button 104.

When selection button 105 is depressed, main control circuit 111 receives the signal indicating the depression and the moving speed of the button section of selection button 105 from depressed selection button 105, and stops the rotations of reels 102a to 102c through performance control circuit 112 after a predetermined time elapses. At this point, main control circuit 111 shortens a time necessary to stop reels 102a to 102c as the moving speed of the button section of selection button 105 increases. At a time point all reels 102a to 102c are stopped, when the same graphics are arrayed in line across all the reels along the prize line, main control circuit 111 ejects the predetermined number of tokens corresponding to the graphic through the token ejection port. In this case, performance control circuit 111 may output a sound effect different from a sound effect, which is output when the reels rotate or when the same graphic are not arrayed in line across all the reels along the prize line, through the speaker.

Thus, those skilled in the art can make various changes without departing from the scope of the present invention.

### DESCRIPTION OF SYMBOLS

- 1, 10, 20: pushbutton device
- 2: case base
- 21: sidewall
- 22: bottom plate
- 23, 24: projection
- 3: case cover
- 31: opening
- 32: projection
- 4: button section
- 41: button upper portion
- 42: button lower portion
- 43: fringe
- 44: projection
- 5-1 to 5-8: magnet
- 6: magnetic sensor
- 61: magnetic sensitive surface
- 7: sensing circuit
- 71: analog-to-digital converter
- 72: memory
- 73: arithmetic circuit
- 8: optical sensor
- 81: light emitting element
- 82: light receiving element
- 100: game machine
- 101: body chassis
- 102a to 102c: reel
- 103: operation button
- 104: start button
- 105: selection button
- 106: light emitting diode
- 110: control circuit
- 111: main control circuit
- 112: performance control circuit
- 113: power supply circuit

## Claims

1. A pushbutton device comprising: a button section configured to be movable along a predetermined direction, the button section comprising a first member located on an opposite side to a depression side;
a support section configured to movably support the button section along the predetermined direction;
a plurality of first magnets opposed to the first member by the support section, the plurality of first magnets being fixed so as to surround a center of the button section, the plurality of first magnets comprising a first magnetic pole on a side opposed to the first member;
a plurality of second magnets arranged at a position farther away from the center of the button section by a predetermined distance than each of the plurality of first magnets or at a position closer to the center of the button section by the predetermined distance than the first magnet, the plurality of second magnets comprising the first magnetic pole on the side opposite to the first magnet; and
a sensor configured to sense that the button section is depressed by a predetermined amount.

2. The pushbutton device according to claim 1, wherein each of the plurality of first magnets and the plurality of second magnets is arranged along a straight line extending radially from the center of the button section.

3. A game machine comprising: the pushbutton device according to claim 1 or 2; and
a control circuit configured to control, when receiving a signal expressing depression from the pushbutton device, operation of the game machine in response to the signal.
